# EUROPEAN PATENT SPECIFICATION

(11) **EP 0 473 294 B1**
(45) Date of publication and mention of the grant of the patent: **22.09.2004**
(21) Application number: 91307037.1
(22) Date of filing: 31.07.1991
(51) Int. Cl.: H01L 27/146, H04N 3/15

(54) **Photoconversion device**
Photoumwandlerschaltung
Dispositif de photo conversion

(30) Priority: 07.08.1990 JP 20757190; 15.10.1990 JP 27321290; 15.10.1990 JP 27321390; 15.10.1990 JP 27321490
(43) Date of publication of application: 04.03.1992
(73) Proprietor: CANON KABUSHIKI KAISHA, Tokyo (JP)
(72) Inventor: Hashimoto, Seiji, c/o Canon Kabushiki Kaisha, Ohta-ku, Tokyo (JP); Shinohara, Mahito, c/o Canon Kabushiki Kaisha, Ohta-ku, Tokyo (JP)
(74) Representative: Beresford, Keith Denis Lewis

(56) References cited:
- EP-A- 0 132 076
- EP-A- 0 253 678
- EP-A- 0 277 016

## Description

The present invention relates to a photoconversion device and to operating and refreshing methods for the photoconversion device.

The present invention is usable with a photoconversion element of the type in which charge carriers generated in response to incident light are stored in a control region of a transistor, and a signal related to the quantity of stored carriers is read out through a main electrode region. An element of this type, which is capable of providing an output signal in which the stored charge is amplified, is known from EP-A-0132076. The photoconversion element of that document is a bipolar transistor, and the carriers are stored in the base. The signal may be read out through the collector or the emitter. The base potential may be controlled via a capacitively coupled electrode, but the present invention is not limited to this. Also, the present invention is not limited to bipolar devices.

EP-A-0132076 discloses an operation cycle for its photoconversion element in which incident light causes electrical carriers to be accumulated in the control region of the element during an accumulation period, a signal dependent on the amount of accumulated charge is read out through a main electrode region during a read period, and then the state of the control region is reset to a standard condition during a reset or refresh period.

EP-A-0222624 and EP-A-0253678 disclose a preferred arrangement in which two reset or refresh operations are carried out in succession. The first is a so-called complete refresh, in which charge carriers are injected into the control region at least in the condition that it has been exposed to very little light during the accumulation period so that the quantity of stored charge is very low, or alternatively the control region potential is set to a defined level, in either case in order to ensure that the control region has a greater quantity of stored charges in it than it has at the end of an accumulation period in which no light has been incident on the photoconversion element. This is followed by a so-called transient refresh operation in which the photoconversion element is biased so that charges stored in the control region flow out through a main electrode region.

This two-step refresh process has been found to be advantageous compared with using a transient refresh process alone. If the transient refresh condition is maintained for long enough, substantially all of the stored charges in the control region can be removed. However, if the transient refresh condition is maintained only for a relatively short time, enabling a faster operation of the photoconversion device, the level of stored charge in the control region is brought down to some particular non-zero standard level, provided that the level of stored charge was sufficiently above the standard level before the transient refresh operation began. However, where the stored charges are already at the standard level before the transient refresh operation begins, e.g. because the photoconversion element has not received any light during the accumulation period, the level of stored charges decreases slightly during the transient refresh operation so as to finish at a level below the standard level. Thus the level of stored charge in a photoconversion element which is not receiving light will slowly decrease during successive exposure periods, and when it next receives light its output signal will not be correct. By conducting a complete refresh operation before the transient refresh operation, it can be ensured that the control region contains sufficient stored charge at the beginning of the transient refresh operation to bring the level of stored charge to the standard level at the end of the transient refresh operation.

In the arrangements disclosed in the prior art documents discussed above, where a photoconversion device comprises a two-dimensional array of photoconversion elements, the control circuitry typically refreshes the elements of a row simultaneously, and refreshes different rows at different times.

An arrangement is known from EP-A-0274236 in which the photoconversion element is a bipolar transistor and the emitter is held at ground level during a transient refresh operation. During a subsequent accumulation period the emitter is held at a standard voltage which is lower than the collector voltage, so as to limit the voltage to which the base can rise as it accumulates carriers, as a measure against "blooming" following an overflow of carriers from an element receiving very strong light.

EP-A-0132076, EP-A-0222624, EP-A-0253678 and EP-A-0274236 are incorporated herein by reference.

EP-A-0277016 discloses a picture cell for a photoelectric conversion apparatus, comprising a bipolar transistor type photosensor, an electrode capacitively coupled to the base of the sensor, and a MOS transistor formed so that the base of the bipolar sensor is also the source of the MOS transistor. The base of the sensor can be refreshed by applying a voltage to the gate of the MOS transistor to turn it on while the drain of the MOS transistor is at ground. This brings the base of the sensor (which is also the source of the MOS transistor) to a constant potential regardless of the potential accumulated in the sensor during exposure to light. It is also noted that the MOS transistor can be turned on by the application of a voltage to its drain electrode. EP-A-0277016 discloses an embodiment in which a plurality of such unit cells are connected in a line with the drain of the MOS transistor of one unit cell being the source of the MOS transistor (and base of the sensor) of an adjacent unit cell. In each unit cell, the gate of the MOS transistor is connected to the electrode which is capacitively coupled to the base of the sensor, and is also connected to a drive line which is common to the row of cells. At one end of the row of cells the drain of the MOS transistor cannot also form the source of the MOS transistor of the adjacent cell because there is no adjacent cell, and this drain is connected to a fixed voltage. At the other end of the row of cells an additional MOS transistor is provided, with its drain formed by the source of the MOS transistor (and base of the sensor) of the end cell and with its source connected to the same fixed voltage. A voltage pulse in one direction on the common drive line turns on the MOS transistors, thereby connecting the bases of all of the sensors in the row to the fixed voltage, for refreshing. At the end of the pulse, the MOS transistors turn off again. A voltage pulse in the opposite direction on the common drive line acts on the bases of the sensors through the capacitively coupled electrodes, to forward bias the sensors for read-out and also optionally for a forward bias refresh operation. In another embodiment the gate electrode of the MOS transistor of each cell is not connected to the capacitively coupled electrode. Instead, a first drive line is provided connected to the capacitively coupled electrodes of the cells in the row and a second drive line is provided connected to the gate electrodes of the MOS transistors of the row. Therefore the voltage pulse for turning on the MOS transistors is provided on a different control line from the voltage pulse in the opposite direction for forward biassing the sensors. This reduces the total voltage swing applied to the drive line.

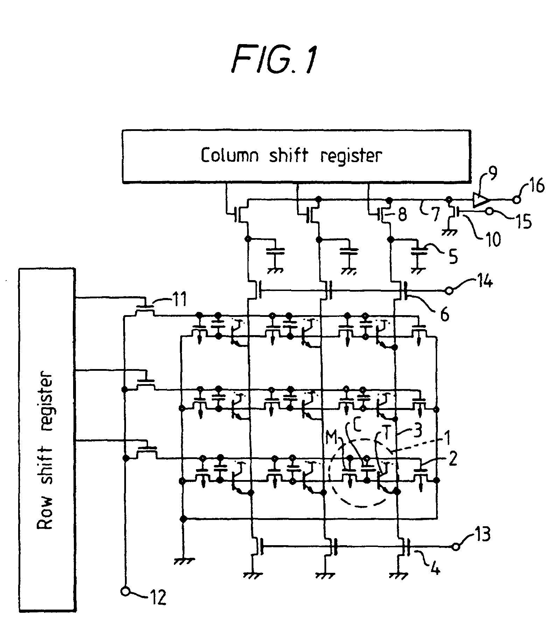

An example of a photoconversion device having a two-dimensional array of photoconversion elements is illustrated in Figure 1. In this Figure, the photoconversion elements are bipolar transistors in which the base is controlled by a capacitively coupled electrode. However, as mentioned above, the present invention is not limited to this type of photoconversion element, and alternative photoconversion elements, including elements without a capacitively coupled control electrode for the control region and elements which are not bipolar transistors, are disclosed in EP-A-0253678.

In Figure 1, a unit picture cell of the array comprises a photoconversion element or sensor (which is a bipolar transistor type device as disclosed in EP-A-0132076) T. The base of the sensor T is capacitively coupled to a control electrode, and this coupling is represented by a capacitor C. Additionally, the base is coupled to a P-channel FET (e.g. a MOSFET) M. Each row of the array of sensors has a common horizontal drive line 2, connected to the capacitor electrode and the gate of the FET M of each cell. Each column of the array has a common vertical output line 3, connected to the emitter of each sensor T. Each vertical output line 3 is connected to ground through a respective FET 4, for resetting the vertical output line 3. Each vertical output line 3 is also connected to a respective capacitor 5 for storing signals output from a sensor T onto the output line 3, through a respective FET 6. Each storage capacitor 5 is connected to a common horizontal output line 7 through a respective FET 8, and the common horizontal output line 7 provides an input to an amplifier 9. The common horizontal output line 7 is also connected to ground through an FET 10.

For controlling the operation of the device, each horizontal drive line 2 is connected through a respective FET 11 to a terminal 12 for supplying drive pulses, and the rows of the array are selected by outputs from a row shift register which turn on the FETs 11 in turn. Control pulses to a terminal 13 turn on the FETs 4 to ground the vertical output lines 3, and control pulses to a terminal 14 to turn on the FETs 6 to connect the vertical output lines 3 to the storage capacitors 5. Outputs from a column shift register selectively turn on the FETs 8 to connect the selected storage capacitors in turn to the common horizontal output line 7. Control pulses to a terminal 15 turn on the FET 10 to ground the horizontal common output line 7 to reset it. The photoconversion output signal from the device is provided from the amplifier 9 to an output terminal 16.

As can be seen in Figure 1, an additional FET M is provided at one end of each row, so that an FET M is present at each end of each row. Except at each end of each row of the array of sensors T, the two main electrode regions (source and drain) of the FET M of each cell are connected respectively to the base of the sensor T of the same cell and the base of the sensor T of an adjacent cell. At each end of each row, the FET connects the base of a sensor T to a line leading to ground. Thus, when a horizontal drive line 2 turns on the FETs of one row of sensors, the bases of all the sensors in the row are connected through the FETs M to ground. The additional FET M in each row can be omitted, in which case the line of FETs is connected to ground at one end only.

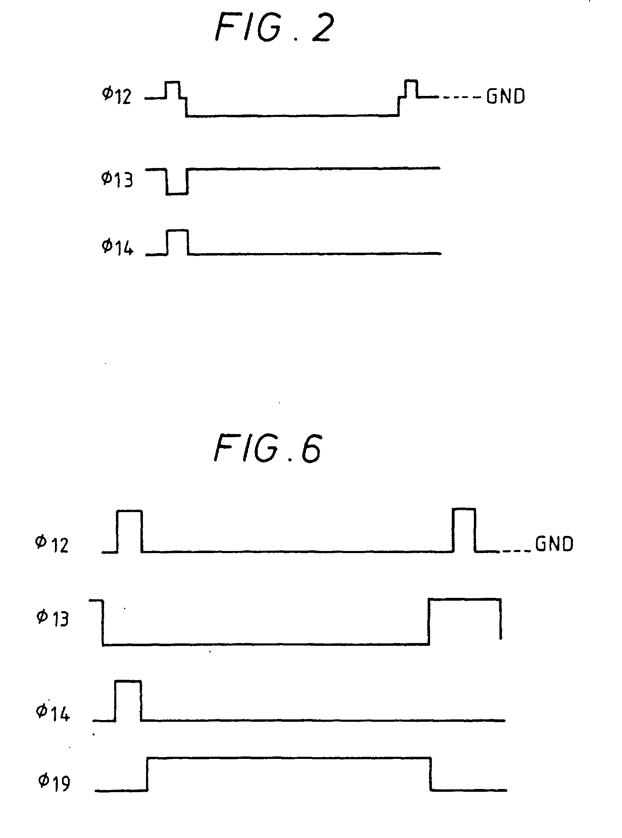

Figure 2 illustrates waveforms of the signals applied to the terminals 12,13 and 14. Throughout this specification the convention will be used that the waveform applied to a terminal will be indicated by Ø followed by the number of the terminal.

During the accumulation period, when the photoconversion device is exposed and charges are accumulated in the base of each sensor T in accordance with the amount of light incident on the sensor, the relevant row of the array of sensors is not selected by the row shift register. If none of the rows is being read or refreshed Ø12 is at ground, Ø13 is high to connect the vertical output lines to ground, and Ø14 is low to isolate the vertical output lines from the storage capacitors 5. When a row is selected for reading and refreshing, the row shift register turns on the corresponding FET 11.

For the reading operation Ø13 goes low to isolate the emitters of the sensors T and the vertical output lines 3 from ground, and Ø14 goes high to connect the emitters and the vertical output lines 3 to the storage capacitors 5. Ø12 goes high sufficiently to raise the potential of the bases of the sensors T in the selected row through the action of the capacitor C to turn on the transistor type sensors T so that an output signal corresponding to the quantity of charges stored in the base region is provided through the emitter region to the respective vertical output line 3 and is stored on the respective storage capacitor 5. The positive pulse of Ø12 firmly turns off the FETs M, so that the base voltage level is not influenced by the ground connection through the FETs M during read-out. Subsequently, the column shift register turns on the FETs 8 in turn to read out the signals from the storage capacitors 5 to the common horizontal output line 7 and the amplifier 9.

For a refreshing operation, Ø13 goes high and Ø14 goes low to isolate the emitters and the vertical output lines 3 from the storage capacitors 5 and connect them again to earth, and Ø12 goes sufficiently low to turn on the P-type FET M. The low-going pulse of Ø12 will initially bias the base of each sensor to turn if off, and then the base of each sensor will become grounded through the FETs M, with charges flowing into or flowing out of the base region depending on the quantity of charge carriers which have been accumulated during the accumulation period. This provides the so-called complete refresh operation, in which the base of each sensor T of the selected row is set to a common potential.

Next, Ø12 goes high once again to turn off the P-type FETs M and forward bias the base of the sensor T relative to the emitter by the action of the capacitor C. The emitter remains connected to ground through the FET 4. This provides the so-called transient reset, during which charges stored in the base region are removed through the emitter region. Because the base of each sensor T of the selected row has been set to a standard level through the FETs M during the complete reset operation, all of the base regions of the sensors in the row are set to a common refresh level at the end of the transient refresh operation.

Ø12 then returns to the ground level to begin the next accumulation period, and the row shift register can turn off the relevant FET 11 to de-select the row.

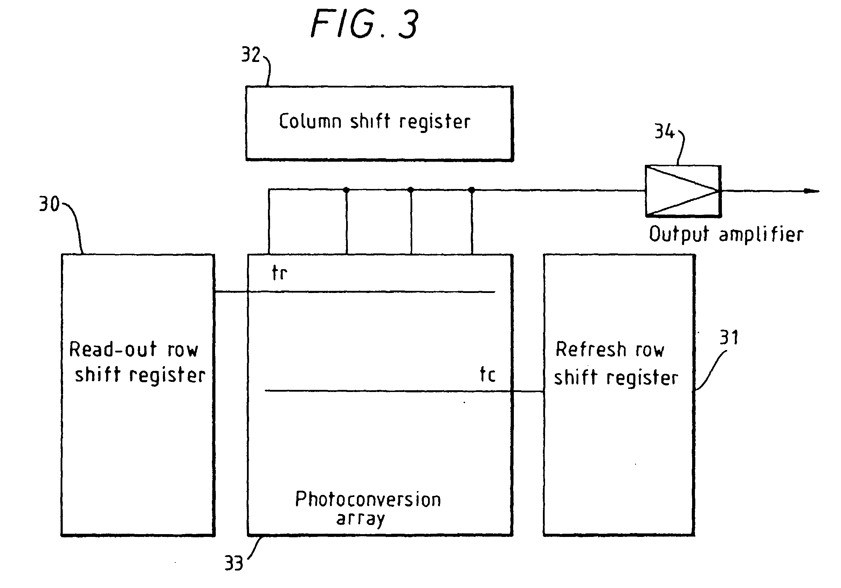

As will be appreciated by those skilled in the art, it is possible to provide an alternative construction in which a first set of horizontal drive lines controlled by a first row shift register are used exclusively for read out, and a second set of horizontal drive lines, controlled by a second row shift register, are used exclusively for refreshing, and such an arrangement is illustrated schematically in Figure 3.

In Figure 3, read out is controlled by a read out row shift register 30 with a timing tR and refresh is controlled by a refresh row shift register 31 with a timing tC. By controlling the period between the drive timing tR of the read out row shift register and the drive timing rC of the refresh row shift register, the accumulation period for each sensor can be controlled, providing the so-called electronic shutter function. In this Figure, a column shift register 32, the photoconversion array 33 and the output amplifier 34 are also illustrated schematically.

The arrangement of Figures 1 and 2 has the advantage that, by providing a common control line for the capacitor electrode controlling the base through capacitor C and the gate of the FET M, the FET M is automatically driven reliably into the off state during read out and the transient refresh operation. However, the total safe voltage range between the highest voltage and the lowest voltage which may be applied to the horizontal drive lines 2, is defined by the characteristics of the components of the photoconversion device, and particularly by their maximum withstand voltages. Consequently, the fact that the horizontal drive lines 2 must go negative in order for the complete refresh operation to be carried out limits the maximum positive voltage which can be applied during transient refresh and read out. This limits the extent to which the transistor type sensor element T can be turned on, so that the read out signal remains relatively low and the maximum output signal when the sensor is saturated by bright light is relatively small. Additionally, the circuit for supplying the drive waveform Ø12 must be relatively complicated as three different levels are required for this waveform.

In the devices of Figures 1 to 3 a problem can arise when a still picture is being taken, for example if the device is used in a still video camera, particularly when a still picture is required of a moving object. Because each row is read and refreshed at a different time, the accumulation periods for different rows are provided with slightly different timings. This results in an image distortion. This image distortion can be eliminated by providing a mechanical shutter which is opened after all of the rows have been refreshed and is closed before any of the rows are read. However, in this case there may still be an undesirable dark current during the time taken to read and refresh all of the picture cells.

The present invention in its various aspects seeks to solve or reduce the various problems discussed above or provide improvements over the arrangements described.

In the present specification reference is made to main electrode regions and control regions of devices. As will be well understood by those skilled in the art, most electrical components have first and second main terminals, such as the two ends of a resistor, and the two terminals of a diode or a capacitor, and in the case of three terminal devices such as transistors, SCRs and TRIACs, a voltage or current between the two main terminals is influenced by a signal at a control terminal. Thus, a bipolar transistor has a main current path between its collector and its emitter, which are main electrode regions, and the base is a control region, and an FET has a main current path between the source and drain, which are main electrode regions. A double-emitter transistor will have two main current paths, one for each emitter.

According to a first aspect of the present invention, as set out in claim 1, there is provided a photoconversion device in which a refresh switch means is turned on to refresh a photoconversion element by varying the voltage applied to a main terminal of the switch means, preferably while keeping the voltage at a control terminal constant. The invention also provides a method of refreshing a photoconversion element as set out in claim 28, a method of operating a photoconversion element as set out in claim 31, and a method of operating a photoconversion device as set out in claim 34. Optional features are set out in the remaining claims.

In an embodiment, the refresh switch means such as FET M is turned on by applying an appropriate voltage to a main terminal rather than by varying the voltage applied to a control terminal, thereby avoiding the need for the refresh control pulse to be applied via a horizontal drive line. In this way, the drive line can provide a greater read pulse voltage without exceeding the safe or stable operating range of the apparatus.

In an embodiment of the present invention storage regions of photoconversion elements of a photoconversion device having an array of elements are connected to a standard voltage for resetting or injecting carriers under at least some conditions of the storage region at the same time for elements of a plurality of rows of the array, and preferably at the same time for all the elements in the array.

In an embodiment of the present invention a control region is refreshed or reset by applying a refresh or reset voltage to a main electrode region of the photoconversion element so as to forward bias the element and refresh or reset the control region through the main electrode region.

In an embodiment of the present invention reset or refresh of a control region of a photoconversion element through a main region of the element is carried out simultaneously for elements in a plurality of rows in a two-dimensional array of such elements, and preferably at the same time for all the elements in the array.

In an embodiment of the present invention the reset or refresh operation of photoconversion elements in a plurality of rows of a two-dimensional array of elements, and preferably all of the elements in the array, is terminated simultaneously. This permits an electronic definition of the beginning of the exposure period without requiring different parts of the array to have different exposure period timings.

In an embodiment of the present invention a read out terminal of a photoconversion element is held at a first level during a period in which charge is accumulated on a control region in response to incident light and is brought to different level before a read out period, the levels being chosen so that there is a voltage for the control region such that charge will flow to the read out terminal when it is at the level provided during the accumulation period but charge will not flow to the read out terminal when it is at the voltage level selected for the read out period. This enables the maximum amount of charge which can be stored in the control region if bright light is incident on the photoconversion element to be limited to a level which provides a margin of safety against the element influencing a signal read onto a common read out line from another element, thereby resisting a "blooming" effect of bright light exposure on one photoconversion element.

Embodiments of the present invention, given by way of non-limiting example, will now be described with reference to the accompanying drawings, in which:
Figure 1 shows a photoconversion device illustrated for the purpose of explanation;
Figure 2 shows a control waveform regime for the operation of the device of Figure 1;
Figure 3 illustrates schematically a device having separate read out and refresh row shift registers;
Figure 4 shows schematically a camera arrangement in which embodiments of the present invention may be used;
Figure 5 shows a photoconversion device according to a first embodiment of the present invention;
Figure 6 shows a control waveform regime for the device of Figure 5;
Figure 7 shows a photoconversion device according to a second embodiment of the present invention;
Figure 8 shows a photoconversion device according to a third embodiment of the present invention;
Figure 9 shows a control waveform regime for the device of Figure 8;
Figure 10 shows an alternative control waveform regime for the device of Figure 8;
Figure 11 shows a photoconversion device according to a further embodiment of the present invention;
Figure 12 illustrates a control waveform regime for the device of Figure 11;
Figure 13 illustrates an alternative control waveform regime for the device of Figure 11; and
Figure 14 illustrates a control waveform regime for the read out period for any of the illustrated photoconversion devices.

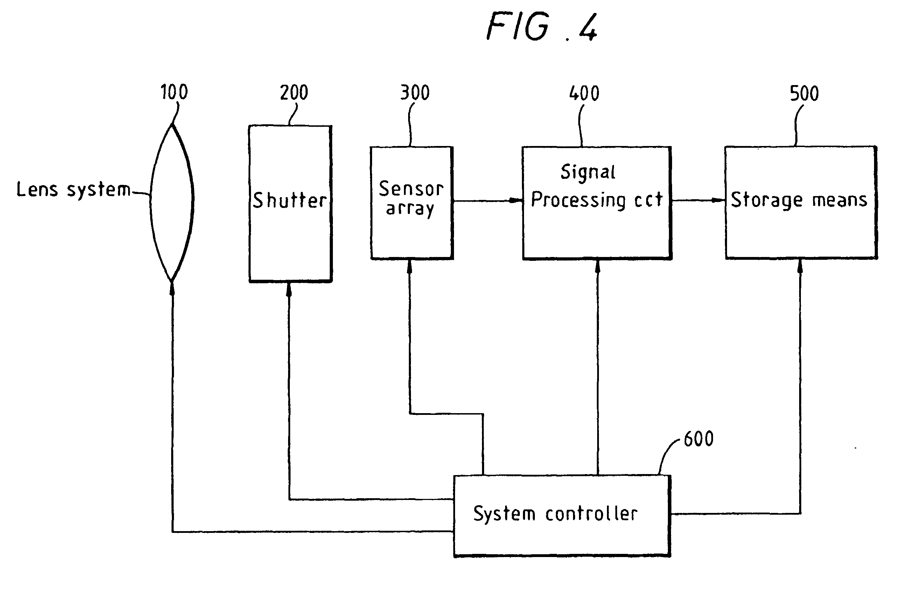

Embodiments of the present invention may be used in a camera system such as is illustrated schematically in Figure 4. Light from a scene passes through a lens system 100 and a mechanical shutter 200 to be imaged on a photoconversion element array of a photoconversion device 300. The opening and closing of the mechanical shutter 200 can control the exposure time of the image on the photoconversion device 300, although the effective exposure period can also be influenced by the optical shutter effect of the sensor reset timing of the photoconversion array as has already been mentioned. A sequential output signal from the photoconversion device 300 is processed in a signal processing circuit 400, and is stored in a storage medium 500 such as a semiconductor memory or a floppy disc. The operations of the components are controlled by a system controller 600. Photoconversion devices embodying the present invention can be used as the photoconversion device 300.

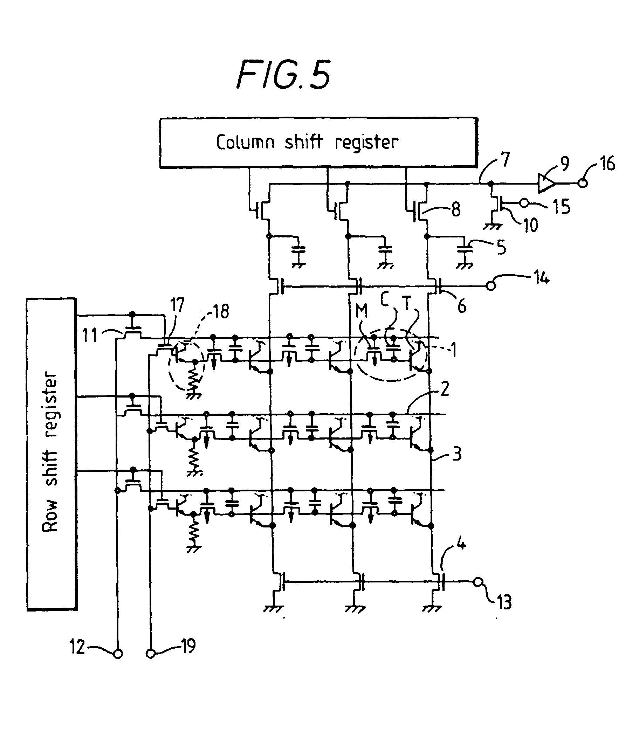

Figure 5 illustrates a first embodiment of the present invention. Many parts of the photoconversion device shown in Figure 5 are the same as in Figure 1, and such parts have been given the same reference numeral. However, as compared with Figure 1 the device of Figure 5 comprises a second FET 17 for each row, also controllable by the row shift register. The main electrode regions (source and drain) of the FETs M of the cells, which are used in the complete reset operation, are connected to the bases of adjacent sensors T of the row, as in Figure 1, except at the ends of the rows. At the ends of the rows, the FETs M are not connected to ground, but are instead connected to the output of respective emitter followers 18 which are provided for each row. The bases of the emitter followers 18 are connected through the respective FETs 17 to a terminal 19. Thus, when the row shift register selects a given row, the source of the reset switch FET M of the end cell is connected to a voltage set by the waveform at the terminal 19. The emitter follower 18 ensures that a high current can be sustained. In this embodiment, the additional FET M at the end of each row is omitted.

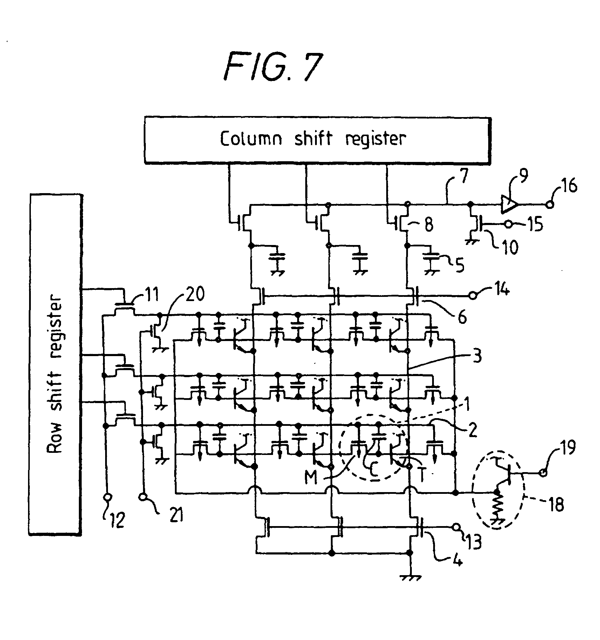

The waveforms at the control terminals 12,13,14,19 in the read and refresh operations of the device of Figure 5 are shown in Figure 6. The reading operation is similar to the operation described with reference to Figure 2 for the device of Figure 1. Thus, Ø13 goes low to separate the vertical output lines 3 from ground, and Ø14 goes high to connect the vertical output lines 3 to the storage capacitors 5. Ø12 goes high, transmitting a high voltage pulse to the horizontal drive line 2 of the selected row through the FET 11 which has been turned on by the row shift register. The row shift register will also have turned on the FET 17 for the selected row, but Ø19 remains low so that the source of the FET switch M of the end cell is at earth as in the arrangement of Figure 1. The high voltage pulse on the horizontal drive line 2 is transmitted through the capacitors C of each cell of the selected row to the bases of the bipolar transistor type sensor elements T, which turn on. Accordingly, read out signals are placed on the vertical output lines 3 and are stored in the storage capacitors 5.

For the complete refresh operation, by which the bases of the sensors T are set to a predefined voltage level, Ø12 returns to ground, but does not go negative as in the device of Figure 1. Instead, Ø19 goes positive, raising the source voltage of the end reset FET M, through the emitter follower 18. Thus, the FET M turns on by having its source voltage raised instead of by having its gate voltage lowered. When it has turned on, it applies the voltage from terminal 19 to the base of its associated sensor T, and also to the source of the next reset FET M. Consequently, the next reset FET M turns on in the same way, and in this manner all of the reset FETs M are turned on and the bases of all of the sensors T in the selected row are reset by the voltage at control terminal 19 through the emitter follower 18. This is the complete refresh operation.

At the end of the complete refresh operation Ø19 goes low again and the transient reset operation is carried out. This is similar to the transient reset operation of Figures 1 and 2. Ø13 is high to connect the emitters to ground through the vertical output lines 3, and Ø12 goes high to forward bias the bases of the sensors T relative to the emitters, so that the quantity of stored charge falls to the predefined level.

Subsequently, Ø12 falls again, reverse biasing the base-emitter junction, and the next accumulation period begins.

Because the complete refresh operation is carried out by driving the sources of the reset switch FETs M high from terminal 19 rather than by driving their gates low from terminal 12, the voltage on the horizontal drive lines 2 does not need to go negative, and accordingly a higher positive read out control voltage can be provided without the total voltage range on the horizontal drive line 2 being excessive. Thus, a higher level read out signal can be obtained. Additionally, the waveforms at each of the terminals 12,19 varies only between two voltages, and so the control circuitry may be less complex than the circuitry required to provide the three level waveform at terminal 12 in the arrangement of Figures 1 and 2.

Figure 7 illustrates a second embodiment of the present invention. In this embodiment, the end FET transistors M of each row are connected together, and are connected to the output of a single common emitter follower structure 18. Additionally, each horizontal drive line 2 is connected to ground through a respective FET 20, which is controlled by a common control terminal 21.

In this embodiment the complete refresh operation for all the cells of the two-dimensional array is carried out simultaneously. A high voltage is applied to terminal 21, to connect all of the horizontal drive lines 2 to ground independently of the operation of the row shift register. In this condition, the high voltage is applied to control terminal 19 to raise the source terminals of the refresh FETs M of the end cells of each row through the emitter follower structure 18. In this way, the complete refresh operation is carried out as described with reference to Figures 5 and 6, except that all of the cells are freshed in a single complete refresh operation. Subsequently, the transient refresh operation may be carried out for each row in succession, in accordance with the selection by the row shift register, in the manner already described.

This embodiment has the advantages of the embodiment of Figure 5, and additionally less time is required for the complete refresh operation since only a single operation is required to provide complete refresh for all rows. This embodiment is usable in a still video camera, for example.

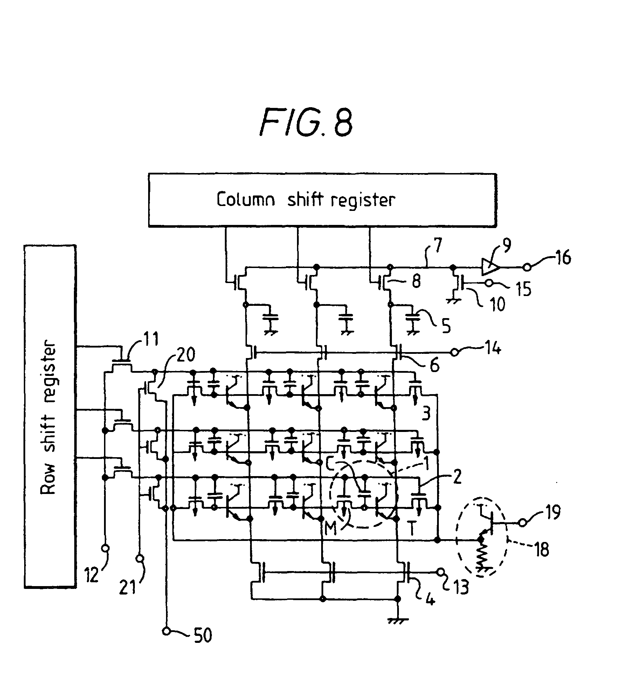

Figure 8 shows a third embodiment of the present invention. This embodiment is similar to the embodiment of Figure 7, except that the FETs 20 do not connect the horizontal drive lines 2 to ground, but instead connect them to a further control terminal 50. With this arrangement, it is possible to connect all of the horizontal drive lines 2 to the terminal 50 simultaneously, and provide a high pulse on the terminal 50 so that a transient refresh operation can be carried out simultaneously for all of the cells of the array.

As will be appreciated by those skilled in the art, the provision of the terminal 50 also means that the complete refresh operation can be carried out simultaneously for all the cells of the array even if the end FETs M of each row are connected to ground as in Figure 1 and the emitter follower arrangement 18 and the terminal 19 are not provided. A simultaneous complete refresh operation could in this case be provided by connecting all of the horizontal drive lines 2 to the terminal 50 through the FETs 20, and applying a negative voltage to the terminal 50. However, this is less advantageous than the structure of Figure 8, since it means that the horizontal drive line 2 must carry a negative voltage at times, thereby reducing the maximum positive voltage which can safely be applied to the line.

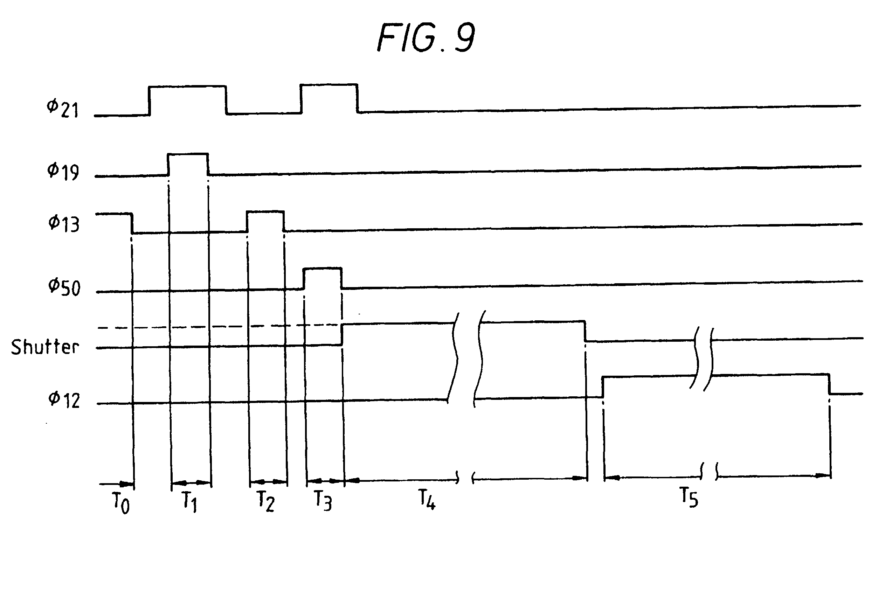

Figure 9 is a timing diagram for the control waveforms for the embodiment of Figure 8. Figure 9 shows a control regime in which two separate transient refresh operations are carried out after the complete refresh operation.

According to Figure 9, at an initial period T0 the shutter may be either open or closed. Ø13 is high, so that the emitters of the photoconversion element sensors T are connected to ground. It is particularly desirable to connect the emitters to ground if the shutter is open, in case strong light is incident on the photoconversion device so that a large quantity of charges are stored in the base of the sensors T. In this case, the grounding of the emitters enables excessive charges in the base to drive the base-emitter junction into forward bias, and the excessive charges are then led off to ground through the emitter. If the emitter is not grounded, the base voltage can continue to rise in bright light, taking the emitter voltage up with it. In this case, there is a possibility that during the complete reset operation the base will be set to a voltage below the emitter voltage, and it may then become difficult to forward bias the base-emitter junction during a subsequent transient reset operation, so that the transient reset operation does not correctly reset the base voltage.

The complete refresh operation is carried out in period T1. Ø21 goes high, turning on the FETs 20 and connecting the horizontal drive lines 2 to the terminal 50. The terminal 50 stays at ground. Ø19 goes high, and this voltage is applied through the emitter follower 18 to the refresh FETs M, turning them on, so that the bases of the sensors T are refreshed in the manner described above.

Following the simultaneous complete refresh in period T1, Ø19 and Ø21 go low and during period T2 Ø13 goes high to reconnect the emitters of the sensors T to ground. This provides a first simultaneous transient refresh operation.

In period T3, a second simultaneous transient refresh operation is carried out. Ø21 goes high again to connect the horizontal drive lines 2 to the terminal 50, and Ø50 goes high to drive the bases of the sensors T high through the capacitors C. Preferably, Ø21 is higher than Ø50 during this period, to avoid the high voltage on the terminal 50 adversely affecting the turn-on characteristics of the FETs 20.

At the end of the second simultaneous transient refresh period T3, the charge accumulation period (exposure period) T4 begins, and the shutter is opened if it was not already open. If the shutter was already open, the end of the second simultaneous transient refresh period T3 begins the exposure period through the so-called electronic shutter effect. As is shown in Figure 9, the exposure period T4 is ended by the closure of the mechanical shutter 200, and subsequently the photoconversion signals are read out during a read out period T5 in which the voltage at terminal 12 is high and the read out operation is controlled by the row shift register and the column shift register as will be apparent to those skilled in the art.

In this embodiment, the exposure period may be started by the electronic shutter effect of the end of the second simultaneous transient refresh period T3, such that the timing of the exposure period is the same for all rows because this refresh operation is simultaneous for all rows.

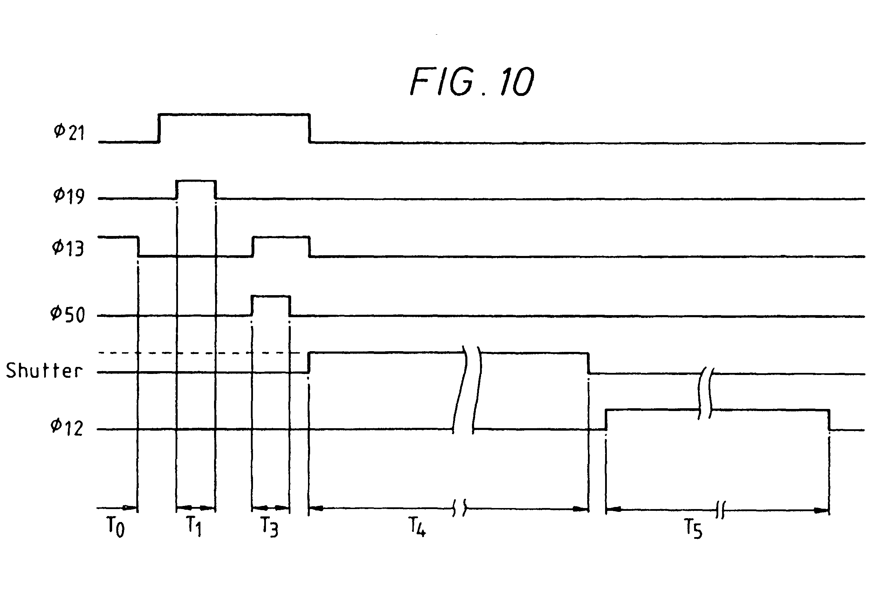

Figure 10 shows an alternative control signal regime for the photoconversion device of Figure 8. In this control regime only a single transient refresh operation is carried out, in period T3, and period T2 is eliminated. The operation of the device in accordance with Figure 10 is substantially the same as its operation in accordance with Figure 9, except that in Figure 10 at the end of the simultaneous complete refresh period T1 the waveform Ø21 remains high, and then in period T3 Ø13 and Ø15 both rise to a high level to carry out a single simultaneous transient refresh operation.

In the control regimes of Figures 9 and 10, all of the refresh operations are simultaneous for all rows of the device. Consequently, the time required for the refresh operations is relatively small, which assists in providing high speed operation of the device.

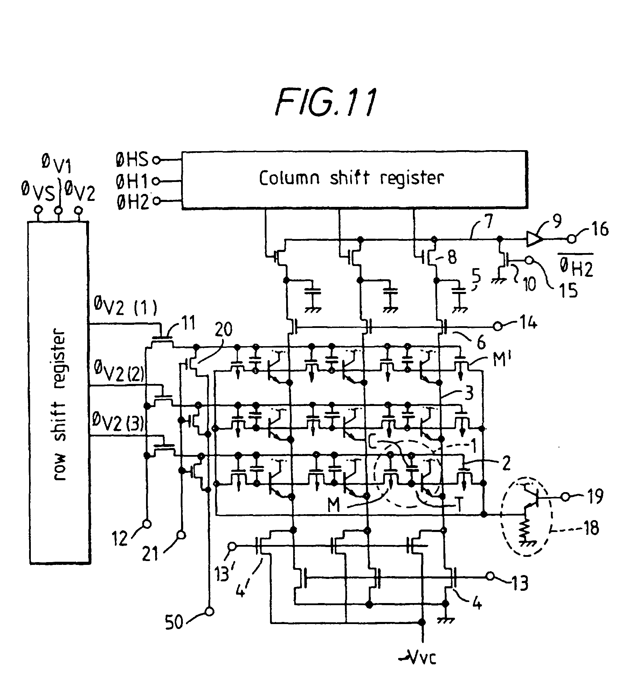

As mentioned above, if very bright light is incident on a photoconversion element before the refresh operations are carried out, the emitter voltage of the element may rise to a high level compared with the level of the base following the complete refresh operation, such that the base-emitter junction is not forward biased, or is not sufficiently forward biased, during a subsequent transient refresh operation. Additionally, the arrangement of the control terminal 19 and the emitter follower 18 means that in the complete refresh operation the base terminals of the sensors T will be set to a voltage higher than ground. The positive pulse applied to the base voltage through the capacitor C for transient refresh drives the base voltage even higher, and there is a possibility that this might lead to undesirably large currents flowing, at least for a brief period, during the transient reset operation. The operation carried out during period T2 assists in reducing these potential difficulties, by setting the emitter voltage to ground before the positive pulse is applied to the base for a transient refresh operation. However, a further embodiment of the present invention, illustrated in Figure 11, is preferred for reducing these difficulties.

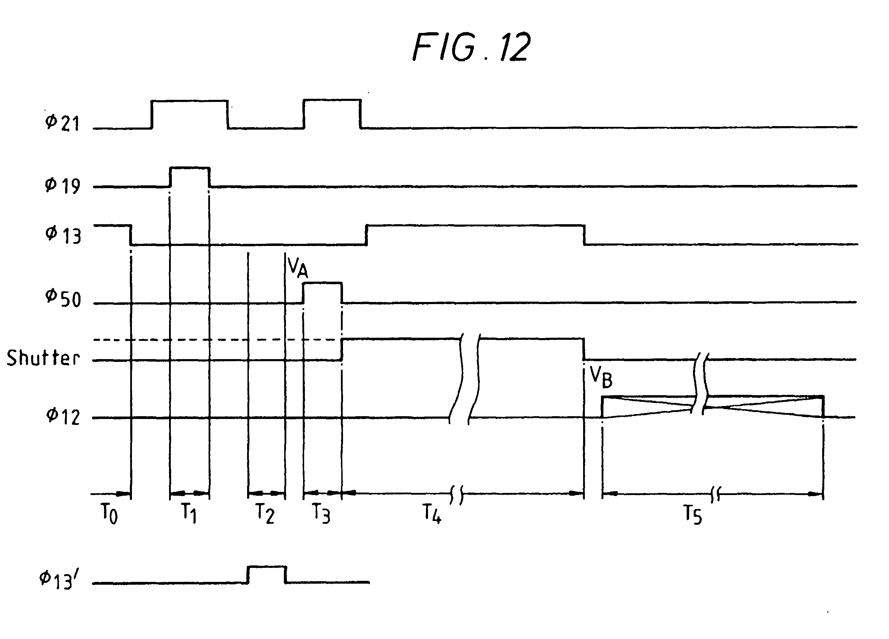

In Figure 11 the device of Figure 8 is further modified by adding FETs 4', controlled by control terminal 13', in parallel with FETs 4, so that the vertical output lines 3 may be connected to ground through the FETs 4 or alternatively to a negative voltage -Vvc through the FETs 4'. A first control regime for this device is shown in Figure 12. This control regime is generally similar to the regime of Figure 9 for the device of Figure 8, except for the period T2.

In Figure 12 during period T2 Ø13 remains low, while Ø13' goes high, so that for the first simultaneous transient refresh operation the emitters of the sensors T are connected to the voltage -Vvc, which is below ground level. Therefore the emitters, and through them the bases, are pulled down strongly. In this way, the voltage on the base of each cell is reduced to be substantially ground level after the end of the first transient refresh operation in period T2, so that during the second transient refresh operation in period T3 a high instantaneous current is avoided even though the base is set to a voltage significantly above ground level during the complete refresh operation. Additionally, the emitter voltage is reliably brought to a low level before the second transient refresh operation is carried out, even if bright light is incident on the photoconversion element T so that the emitter was previously at a high level. Thus, the base-emitter junction can be reliably forward-biased during the second transient refresh operation in period T3.

In the arrangements of Figures 8 and 11 it is preferred that the voltage applied to the terminal 50 for a transient refresh operation, shown as VA in

Figure 12, is less than the voltage applied to the terminal 12 for read out, shown as VB in Figure 12. Voltage VA sets the extent to which the base-emitter junction is reverse biased at the beginning of the exposure period, and by making voltage VB bigger than voltage VA the bipolar transistor type photoconversion element T can be relatively strongly forward biased during read out, so that a sufficient forward bias for an effective high speed read out operation can be achieved regardless of the h_{fe} value of the photoconversion element T.

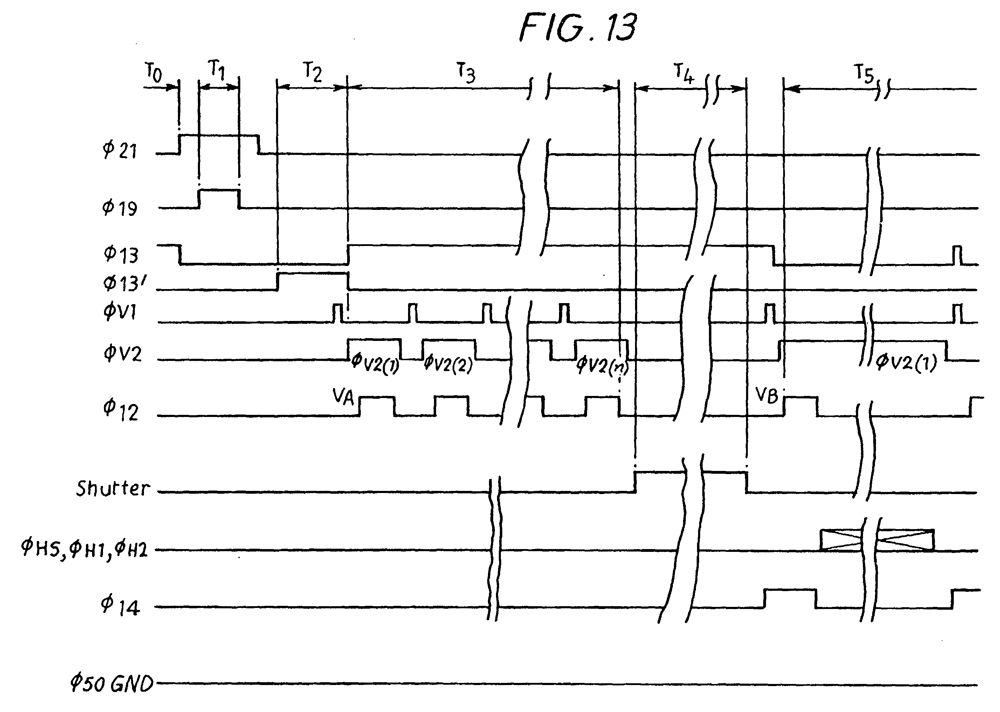

Figure 13 shows an alternative control regime for the device of Figure 11. In this regime, the second transient refresh operation is carried out sequentially for the various lines of the array, rather than simultaneously, so that the currents flowing during the second transient refresh operation are lower. Accordingly, terminal 50 is maintained at ground level, and this terminal may be provided as a direct connection to ground in the manner of the device of Figure 7.

In Figure 13, the operations in periods T0, T1 and T2 are the same as in Figure 12. However, for the second transient refresh operation Ø21 and Ø50 remain low, and instead the control voltage VA for the second transient refresh operation is provided in waveform Ø12 while the row shift register provides row select signals Øv2 to select each row of the array for transient refresh in turn. During the second transient refresh operation Ø13 is high, connecting the emitters of the sensors T to ground through the vertical output line 3 and FETs 4.

Since the bases of the sensors are set to a relatively high voltage during the simultaneous complete refresh operation, a current will tend to flow from each sensor immediately its emitter is connected to ground. Thus, if the sequential transient refresh operation of period T3, in which a positive pulse is applied to the bases of the selected sensors T follows directly after the complete refresh operation, there will be a leak current from the non-selected sensors T in addition to a high current from the strongly forward biased selected sensors T. This is avoided by the preliminary simultaneous transient refresh operation during period T2. Even if the base voltage is above only 0.2 or 0.3 volts after the end of the simultaneous transient reset operation of period T2, a small leak current may flow from the emitters of non-selected sensors during the sequential transient reset operation in period T3. However, because the emitters are set to a lower voltage through the FETs 4' during the simultaneous transient reset operation than the emitter voltage set through the FETs 4 during the sequential transient refresh operation, the non-selected sensors are reliably turned off during the sequential transient refresh operation.

As previously mentioned, it is advantageous if the read out control voltage VB is higher than the transient refresh control voltage VA.

Since the final refresh operation is sequential in Figure 13, the mechanical shutter 200 is kept closed during the refresh operation, and the exposure period T4 begins when the mechanical shutter opens.

As shown in Figure 13, waveform Ø13 is kept high during the exposure period T4, so that if one photoconversion sensor is exposed to very strong light and the cell is effectively saturated, the base-emitter junction will become forward biased and excess charges on the base will flow through the emitter to ground. This reduces problems, such as blooming, associated with strong light exposure of one photosensor element. However, following the ending of the exposure period T4 by closure of the mechanical shutter 200, the image signal is read out on the vertical output lines 3 and a residual portion of the current from a saturated photoconversion cell may be added to the signal on its associated vertical output line 3, so that blooming still occurs to some extent.

This residual blooming effect can be avoided if Ø13 is low during the accumulation period T4 and Ø13' is high. This means that the emitter voltage during the accumulation period is lower than the emitter voltage for the last transient refresh operation in which a positive base voltage is applied to the sensors. If the emitter voltage during the accumulation period is lower by a voltage VABV, the picture cells will saturate at a lower base voltage kVABV (where k is a coefficient for the change of base voltage with change of emitter voltage). By holding the emitter to this lower voltage during the accumulation period, the maximum base voltage which can arise due to bright light is reduced. Following closure of the mechanical shutter 200, the emitter voltage can be returned to the voltage used during the sequential transient reset operation by turning off the FETs 4' and turning on the FETs 4. In this way, a saturation voltage margin is provided corresponding to kVABV, so that a saturated picture cell ceases to be saturated after the end of the exposure period, and therefore it does not influence the vertical output line 3 during the read out period. During the read out period T5 the mechanical shutter is kept closed so that incident light cannot affect the signal during this period, and particularly strong light cannot create blooming.

By keeping the output terminal of the picture cell (i.e. the emitter) at a standard voltage, in this case ground, for substantially the whole of the operation cycle except for the read out period and the simultaneous complete reset period, the reset current can be minimised.

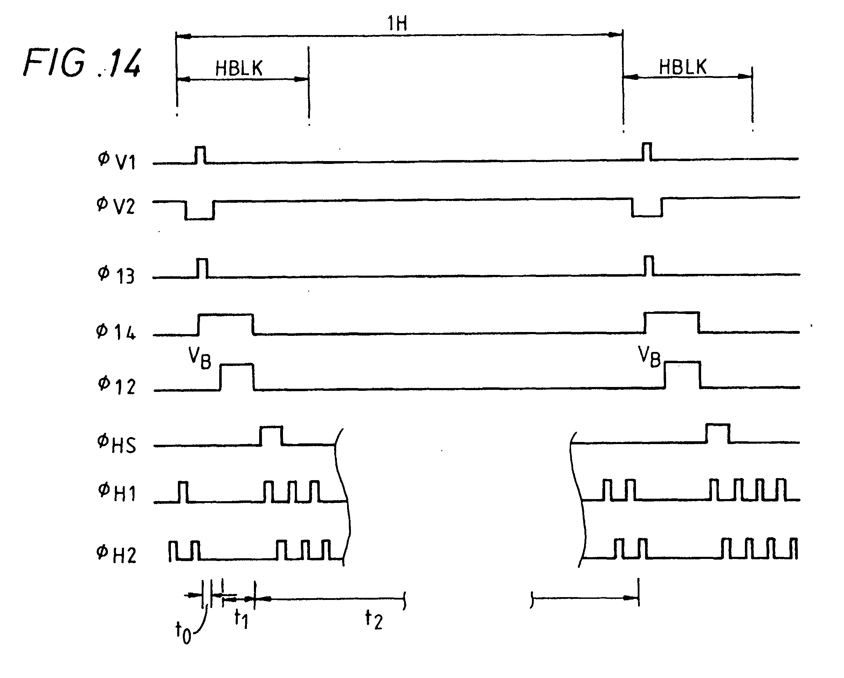

Figure 11 also shows the control signal terminals for the row and column shift registers, and the waveforms for these signals are included in Figures 13 and 14.

ØVS is a vertical synchronising signal (i.e. a field synchronising signal) for resetting the operation of the row shift register. ØV2 carries the waveforms which are output from the row shift register on the selected lines to turn the FETs 11 on and off. ØV1 clocks the row shift register, so that each pulse of ØV1 changes the output line of the row shift register which carries the waveform ØV2. The operation of ØV1 and ØV2 can be seen clearly in Figure 13, in which pulses of ØV2 are output on successive output lines of the row shift register to enable successive rows of the array during the sequential transient refresh operation, and clocking pulses of ØV1 change the selected row. The signals ØHS, ØH1 and ØH2 provide equivalent functions for the column shift register, for the purpose of providing horizontal (row) synchronisation, read out timing and column selection signals within each row read out period.

Figure 14 shows a control regime for the read out period T5. The read out period T5 is divided into horizontal line periods, marked 1H in Figure 14. Each horizontal line period begins with a horizontal blanking period marked HBLK. At the beginning of the horizontal blanking period, in a period t0, ØV2 goes low so that none of the horizontal drive lines 2 is enabled, and ØV1 provides the clock pulse to select the next row of the array. Subsequently ØV2 goes high again to turn on the FET 11 for the next row of the array. Also during the period t0, Ø14 is high to connect the storage capacitors 5 to the vertical output lines 3 through the FETs 6, and Ø13 goes on briefly during the period to connect the vertical output lines 3 to ground through the FETs 4. Thus, before the read out from the selected row begins, residual signals are removed from the storage capacitors 5 and the vertical output lines 3.

At the end of the period t0, ØV1 and Ø13 go low again, but Ø14 remains high, and in a period t1 ØV2 goes high to connect the selected horizontal drive line 2 to terminal 12, and Ø12 rises to the read out voltage VB. Accordingly, the base region of each sensor T of the selected row is raised through the capacitor C, and the output signal is provided to the respective vertical output line 3. Since Ø14 is high, the signal is passed to the respective storage capacitor 5. At the end of the period t1, Ø12 goes low ending the read out operation from the cells, and Ø14 goes low to isolate the storage capacitors 5 from vertical output lines 3. Then, in period t2 the operation of the column shift register is synchronised by ØHS, and the signals stored in the storage capacitors 5 are read out in succession to the common horizontal output line 7, the amplifier 9 and the output terminal 16. This is done by turning on each FET 8 in succession, by the application of waveform ØH2, with the FETs being selected in turn by the clocking action of ØH1. In between the energisations of the FETs 8 to connect successive storage capacitors 5 to the common horizontal output line 7, the common horizontal output line 7 is earthed through FET 10 to remove any residual signal. This may be done by applying the inverse of ØH2 to terminal 15, as shown in Figure 11, or in any other convenient way such as by applying ØH1 to terminal 15 or a specially generated control signal.

As previously mentioned, the read out voltage VB applied to the horizontal drive lines 2 is preferably greater than the transient refresh voltage VA, to ensure that a strong read out signal is provided from the sensors T.

In order to reduce the instantaneous current which flows when the sensors T are forward biased by a positive pulse on the base during transient refresh, the complete refresh voltage applied through emitter follower arrangement 18 may be made as low as possible, as an alternative to providing an operation in which the emitters of the sensors T are pulled down in what amounts to a preliminary transient refresh operation. However, there is a limit to the extent to which the emitter follower voltage can be lowered, since the voltage must be sufficiently high to ensure that the complete reset switch FETs M turn on. Accordingly, the use of the preliminary simultaneous transient reset operation during period T2 is preferred.

The present invention has been described with reference to embodiments given by way of example. Modifications and alternatives will be apparent to those skilled in the art.

## Claims

1. A photoconversion device comprising:
a row of photoconversion elements (T) each of which has first and second main electrode regions and a control region, charges being stored in the control region in response to incident light;
a refresh means comprising (a) a plurality of switch means (M) connected between respective ones of the row of photoconversion elements (T), each switch means (M) having first and second main terminals and a control terminal, the first and second main terminals of each said switch means (M) within the row being coupled respectively to the control regions of the photoconversion elements (T) on either side of it thereby connecting in a series the control regions of the row of photoconversion elements, and a further said switch means (M) at at least one end of the row, the second main terminal of the further switch means being coupled to the control region of the photoconversion element at the end of the row, and (b) means (18,19) arranged to turn on the plurality of switch means (M), for refreshing the control regions of the photoconversion elements (T), by applying a voltage change to the first main terminal of the further switch means (M) at the or each end of the row.

2. A device according to claim 1, comprising means arranged to hold the voltage at the control terminals of the switch means (M) constant during the application of the said voltage change to the first main terminal of the switch means at the or each end of the row.

3. A device according to claim 1 or claim 2, in which the means (18,19) arranged to turn on the switch means comprises an emitter follower (18) with its emitter connected to the first main terminal of the switch means (M) at the or each end of the row and with its base connected to a terminal (19) arranged to receive variations in the voltage to be applied to the first main terminal of the switch means at the or each end of the row.

4. A device according to any one of claims 1 to 3, in which the control terminal of each of the switch means (M) within the row is coupled to a control electrode for controlling the control region of a respective one of the photoconversion elements (T).

5. A device according to claim 4, in which the control electrode is capacitively coupled to the control region of the respective photoconversion element (T).

6. A device according to any one of the preceding claims, in which each of the switch means (M) comprises a field effect transistor.

7. A photoconversion device according to any one of the preceding claims, comprising means (4',13') arranged to alter the potentials of the first main electrode regions of the photoconversion elements (T) to forward bias the control regions relative to the first main electrode regions.

8. A device according to claim 7, in which the said means (4',13') is arranged to alter the potential of the first main electrode regions of substantially all of the photoconversion elements at the same time.

9. A device according to claim 7 or claim 8, in which the refresh means further comprises means (11,12; or 20,21,50) arranged to alter the potential of the control regions of the photoconversion elements (T) to forward bias them relative to the respective first main electrode regions.

10. A photoconversion device according to any one of the preceding claims comprising means (11,12,5,6) arranged to read photoconversion signals from the first main electrode regions of the photoconversion elements (T) during a read-out period, and means (4',13',4,13) arranged to hold the first main electrode regions of the photoconversion elements at a first potential (-Vvc) at a first time during the exposure period and arranged to change the first main electrode regions to a second potential by a second time between the exposure period and the read-out period, the second potential being different from the first potential in a direction tending to reverse-bias the control regions relative to the respective first main electrode regions.

11. A device according to any one of the preceding claims in which each photoconversion element (T) comprises a bipolar transistor, and the control region is a base region.

12. A device according to claim 11, in which the first main electrode region of each photoconversion element (T) is an emitter region.

13. A photoconversion device according to any one of the preceding claims which comprises read means comprising a drive line (2) coupled to the photoconversion elements (T) and to the control terminals of the switch means (M), and (d) means (12) arranged to apply to the drive line (2) a voltage change, in a direction which tends to keep the switch means (M) turned off, for reading a signal from the photoconversion elements (T).

14. A photoconversion device according to any one of the preceding claims in which there is a said further switch means at each end of the row, and the means (18,19) arranged to turn on the plurality of switch means is arranged to do so by applying a voltage change to the first main terminal of the switch means (M) at each end of the row.

15. A photoconversion device according to any one of the preceding claims comprising a plurality of rows of said photoconversion elements (T).

16. A device according to claim 15, in which the plurality of rows form an X-Y addressable array of photoconversion elements.

17. A device according to claim 15 or claim 16 in which the refresh means comprises means (18,19; or 4'13'; or 20,21,50) arranged to conduct a refresh operation for the photoconversion elements of more than one of the rows at the same time.

18. A device according to claim 17, in which the refresh means (18,19) is arranged to set the control region to a predetermined voltage level, at least in the case that the control region voltage differs from the predetermined voltage in a first direction, for the photoconversion elements (T) of more than one of the rows at the same time.

19. A device according to claim 17, in which the refresh means (4',13'; or 20,21,50) is arranged to forward bias the control region, relative to the first main electrode region, of the photoconversion elements (T) of more than one of the rows at the same time.

20. A device according to claim 19, in which the refresh means (20,21,50) is arranged to forward bias the control regions relative to the first main electrode regions by altering the potential of the control regions.

21. A device according to claim 19, in which the refresh means (4',13') is arranged to forward bias the control regions relative to the first main electrode regions by altering the potential of the first main electrode regions.

22. A device according to any one of claims 17 to 21, in which the refresh means comprises further means (4',13'; or 20,21,50; or 11,12) arranged to conduct a further refresh operation for the photoconversion elements.

23. A device according to claim 22, in which the further means (4',13'; or 20,21,50) is arranged to conduct a further refresh operation at the same time for the photoconversion elements of more than one of the rows.

24. A device according to claim 22, in which the further means (11,12) is arranged to conduct a further refresh operation at different times for photoconversion elements of different rows.

25. A device according to any one of claims 22 to 24, in which the further means (4',13'; or 20,21,50; or 11,12) is arranged to refresh a photoconversion element by forward biasing the control region relative to the first main electrode region.

26. A device according to claim 25, in which the further means (20,21,50; or 11,12) is arranged to forward bias the control region relative to the first main electrode region by altering the potential of the control region.

27. A device according to claim 25, in which the further means (4',13') is arranged to forward bias the control region relative to the first main electrode region by altering the potential of the first main electrode region.

28. A method of refreshing the control regions of a row of photoconversion elements of a photoconversion device according to any one of the preceding claims in which the said switch means (M) at the or each end of the row is turned on by varying the voltage applied to its first main terminal.

29. A method according to claim 28 in which the voltage at the control terminals of the switch means (M) is held constant while the voltage applied to the first main terminal of the switch means at the or each end of the row is varied to turn it on.

30. A method according to claim 28 or claim 29, which includes the step of altering the potential of the first main electrode regions of the photoconversion elements of the row to forward bias the control regions relative to the first main electrode regions.

31. A method of operating a row of photoconversion elements (T) in a photoconversion device according to claim 13 or any one of claims 14 to 27 as dependent directly or indirectly on claim 13, comprising refreshing the photoconversion elements by a method according to any one of claims 28 to 30, and reading signals from the photoconversion elements (T) by varying the voltage of the drive line (2) in a direction which tends to keep the switch means (M) turned off.

32. A method according to claim 31 comprising holding the first main electrode regions of the photoconversion elements at a first voltage (-Vvc) at a first time during an exposure period in which charges are stored in the control region in response to incident light, and reading photoconversion signals from the first main electrode region during a read-out period,
the method further comprising the step of bringing the first main electrode regions to a second voltage by a second time between the exposure period and the read-out period, the second voltage differing from the first voltage in the direction tending to reverse bias the control regions relative to the respective first main electrode regions.

33. A method according to claim 32, which comprises refreshing the photoconversion elements before the exposure period by an operation including the step of forward biasing the control regions relative to the respective first main electrode regions while holding the first main electrode regions at the second voltage.

34. A method of operating a photoconversion device according to any one of claims 1 to 27, the photoconversion device comprising a plurality of rows of said photoconversion elements (T), the method comprising operating the elements by a method according to any one of claims 31 to 33 or refreshing the elements by a method according to any one of claims 28 to 30, in which photoconversion elements (T) of a plurality of rows are refreshed at the same time.

35. A method according to claim 34, in which the photoconversion device comprises a shutter (200), and the method comprises opening the shutter before the said step of refreshing the photoconversion elements.

## Patentansprüche

1. Fotowandlerschaltung, mit
einer jeweiligen Zeile von Fotowandlerelementen (T), die jeweils einen ersten und einen zweiten Hauptelektrodenbereich und einen Steuerbereich aufweisen, wobei in dem Steuerbereich in Abhängigkeit von einfallendem Licht Ladungen gespeichert werden, und
einer Auffrischungseinrichtung, die
(a) eine Vielzahl von zwischen die jeweiligen Zeilen der Fotowandlerelemente (T) geschalteten Schaltelementen (M), die jeweils einen ersten und einen zweiten Hauptanschluss sowie einen Steueranschluss aufweisen, wobei der erste und der zweite Hauptanschluss eines jeden Schaltelements (M) in der Zeile jeweils mit den Steuerbereichen der auf dessen beiden Seiten anordneten Fotowandlerelemente (T) verbunden sind und hierdurch die Steuerbereiche der Zeile von Fotowandlerelementen in Reihenschaltung miteinander verbinden, sowie ein an zumindest einem Ende der Zeile angeordnetes weiteres Schaltelement (M) umfasst, dessen zweiter Hauptanschluss mit dem Steuerbereich des am Ende der Zeile angeordneten Fotowandlerelements verbunden ist, und
(b) eine Einrichtung (18, 19) zum Durchschalten der Vielzahl von Schaltelementen (M) zur Auffrischung der Steuerbereiche der Fotowandlerelemente (T) durch Anlegen einer Spannungsänderung an den ersten Hauptanschluss des an dem oder an jedem Ende der Zeile angeordneten weiteren Schaltelements (M) aufweist.

2. Fotowandlerschaltung nach Anspruch 1, mit einer Einrichtung, die die Spannung an den Steueranschlüssen der Schaltelemente (M) während des Anlegens der Spannungsänderung an den ersten Hauptanschluss des an dem oder an jedem Ende der Zeile angeordneten Schaltelements konstant hält.

3. Fotowandlerschaltung nach Anspruch 1 oder 2, bei der die zum Durchschalten der Schaltelemente vorgesehene Einrichtung (18, 19) einen Emitterfolger (18) aufweist, dessen Emitter mit dem ersten Hauptanschluss der an dem oder an jedem Ende der Zeile angeordneten Schaltelement (M) und dessen Basis mit einem Anschluss (19) verbunden sind, der mit den dem ersten Hauptanschluss des an dem oder an jedem Ende der Zeile angeordneten Schaltelements zuzuführenden Spannungsänderungen beaufschlagt wird.

4. Fotowandlerschaltung nach zumindest einem der Ansprüche 1 bis 3, bei der der Steueranschluss eines jeden Schaltelements (M) in der Zeile mit einer Steuerelektrode zur Steuerung des Steuerbereichs eines jeweiligen Fotowandlerelements (T) verbunden ist.

5. Fotowandlerschaltung nach Anspruch 4, bei der die Steuerelektrode mit dem Steuerbereich des jeweiligen Fotowandlerelements (T) kapazitiv gekoppelt ist.

6. Fotowandlerschaltung nach zumindest einem der vorhergehenden Ansprüche, bei der jedes Schaltelement (M) einen Feldeffekttransistor umfasst.

7. Fotowandlerschaltung nach zumindest einem der vorhergehenden Ansprüche, mit einer zur Änderung der Potentiale der ersten Hauptelektrodenbereiche der Fotowandlerelemente (T) ausgestalteten Einrichtung (4', 13'), die die Steuerbereiche in Relation zu den ersten Hauptelektrodenbereichen in Durchlassrichtung vorspannt.

8. Fotowandlerschaltung nach Anspruch 7, bei der die Einrichtung (4', 13') zur gleichzeitigen Änderung des Potentials der ersten Hauptelektrodenbereiche von im wesentlichen sämtlichen Fotowandlerelementen ausgestaltet ist.

9. Fotowandlerschaltung nach Anspruch 7 oder 8, bei der die Auffrischungseinrichtung eine Einrichtung (11, 12; oder 20, 21, 50) aufweist, die zur Änderung des Potentials der Steuerbereiche der Fotowandlerelemente (T) ausgestaltet ist, um sie in Relation zu den jeweiligen ersten Hauptelektrodenbereichen in Durchlassrichtung vorzuspannen.

10. Fotowandlerschaltung nach zumindest einem der vorhergehenden Ansprüche, mit einer Einrichtung (11, 12, 5, 6), die zum Auslesen von fotoelektrisch umgesetzten Signalen aus den ersten Hauptelektrodenbereichen der Fotowandlerelemente (T) während einer Leseperiode ausgestaltet ist, und einer Einrichtung (4', 13', 4, 13), die die ersten Hauptelektrodenbereiche der Fotowandlerelemente während einer ersten Zeitdauer bei einer Belichtungsperiode auf einem ersten Potential (-Vvc) hält, und die ersten Hauptelektrodenbereiche während einer zwischen der Belichtungsperiode und der Leseperiode liegenden zweiten Zeitdauer an ein zweites Potential legt, das von dem ersten Potential in einer Richtung abweicht, in der die Steuerbereiche in Relation zu den jeweiligen ersten Hauptelektrodenbereichen in Sperrichtung vorgespannt werden.

11. Fotowandlerschaltung nach zumindest einem der vorhergehenden Ansprüche, bei der jedes Fotowandlerelement (T) einen bipolaren Transistor umfasst und der Steuerbereich von einem Basisbereich gebildet wird.

12. Fotowandlerschaltung nach Anspruch 11, bei der der erste Hauptelektrodenbereich eines jeden Fotowandlerelementes (T) von einem Emitterbereich gebildet wird.

13. Fotowandlerschaltung nach zumindest einem der vorhergehenden Ansprüche, mit
(c) einer Leseeinrichtung, die eine mit den Fotowandlerelementen (T) und den Steueranschlüssen der Schaltelemente (M) verbundene Ansteuerleitung (2) aufweist, und
(d) einer Einrichtung (12), über die die Ansteuerleitung (2) zum Auslesen eines Signals aus den Fotowandlerelementen (T) mit einer Spannungsänderung in einer Richtung beaufschlagbar ist, in der die Schaltelemente (M) gesperrt gehalten werden.

14. Fotowandlerschaltung nach zumindest einem der vorhergehenden Ansprüche, bei der eines der weiteren Schaltelemente an jedem Ende der Zeile angeordnet ist und die Einrichtung (18, 19) zum Durchschalten der Vielzahl von Schaltelementen dahingehend ausgestaltet ist, dass dies durch Anlegen einer Spannungsänderung an den ersten Hauptanschluss des an jedem Ende der Zeile befindlichen Schaltelementes (M) erfolgt.

15. Fotowandlerschaltung nach zumindest einem der vorhergehenden Ansprüche, die eine Vielzahl von Zeilen der Fotowandlerelemente (T) aufweist.

16. Fotowandlerschaltung nach Anspruch 15, bei der die Vielzahl von Zeilen eine X-Y-adressierbare Anordnung von Fotowandlerelementen bildet.

17. Fotowandlerschaltung nach Anspruch 15 oder 16, bei der die Auffrischungseinrichtung eine Einrichtung (18, 19; oder 4', 13'; oder 20, 21, 50) aufweist, die zur gleichzeitigen Durchführung eines Auffrischungsvorgangs für die Fotowandlerelemente von mehr als einer der Zeilen ausgestaltet ist.

18. Fotowandlerschaltung nach Anspruch 17, bei der die Auffrischungseinrichtung (18, 19) dahingehend ausgestaltet ist, bei den Fotowandlerelementen (T) von mehr als einer der Zeilen zumindest dann, wenn die Steuerbereichsspannung von der vorgegebenen Spannung in einer ersten Richtung abweicht, gleichzeitig den Steuerbereich auf einen vorgegebenen Spannungspegel einzustellen.

19. Fotowandlerschaltung nach Anspruch 17, bei der die Auffrischungseinrichtung (4', 13'; oder 20, 21, 50) dahingehend ausgestaltet ist, bei den Fotowandlerelementen (T) von mehr als einer der Zeilen gleichzeitig den Steuerbereich in Relation zu dem ersten Hauptelektrodenbereich in Durchlassrichtung vorzuspannen.

20. Fotowandlerschaltung nach Anspruch 19, bei der die Auffrischungseinrichtung (20, 21, 50) dahingehend ausgestaltet ist, die Steuerbereiche in Relation zu den ersten Hauptelektrodenbereichen durch Änderung des Potentials der Steuerbereiche in Durchlassrichtung vorzuspannen.

21. Fotowandlerschaltung nach Anspruch 19, bei der die Auffrischungseinrichtung (4', 13') dahingehend ausgestaltet ist, die Steuerbereiche in Relation zu den ersten Hauptelektrodenbereichen durch Änderung des Potentials der ersten Hauptelektrodenbereiche in Durchlassrichtung vorzuspannen.

22. Fotowandlerschaltung nach zumindest einem der Ansprüche 17 bis 21, bei der die Auffrischungseinrichtung eine weitere Einrichtung (4', 13'; oder 20, 21, 50; oder 11, 12) zur Durchführung eines weiteren Auffrischungsvorgangs für die Fotowandlerelemente aufweist.

23. Fotowandlerschaltung nach Anspruch 22, bei der die weitere Einrichtung (4', 13'; oder 20, 21, 50) dahingehend ausgestaltet ist, einen weiteren Auffrischungsvorgang gleichzeitig für die Fotowandlerelemente von mehr als einer der Zeilen durchzuführen.

24. Fotowandlerschaltung nach Anspruch 22, bei der die weitere Einrichtung (11, 12) dahingehend ausgestaltet ist, einen weiteren Auffrischungsvorgang zu unterschiedlichen Zeiten für die Fotowandlerelemente von unterschiedlichen Zeilen durchzuführen.

25. Fotowandlerschaltung nach zumindest einem der Ansprüche 22 bis 24, bei der die weitere Einrichtung (4', 13'; oder 20, 21, 50; oder 11, 12) dahingehend ausgestaltet ist, ein Fotowandlerelement wieder aufzufrischen, indem der Steuerbereich in Relation zu dem ersten Hauptelektrodenbereich in Durchlassrichtung vorgespannt wird.

26. Fotowandlerschaltung nach Anspruch 25, bei der die weitere Einrichtung (20, 21, 50; oder 11, 12) dahingehend ausgestaltet ist, den Steuerbereich in Relation zu dem ersten Hauptelektrodenbereich durch Änderung des Potentials des Steuerbereichs in Durchlassrichtung vorzuspannen.

27. Fotowandlerschaltung nach Anspruch 25, bei der die weitere Einrichtung (4', 13') dahingehend ausgestaltet ist, den Steuerbereich in Relation zu dem ersten Hauptelektrodenbereich durch Änderung des Potentials des ersten Hauptelektrodenbereichs in Durchlassrichtung vorzuspannen.

28. Verfahren zur Auffrischung der Steuerbereiche einer Zeile von Fotowandlerelementen einer Fotowandlerschaltung nach zumindest einem der vorhergehenden Ansprüche, bei dem das Schaltelement (M) an dem oder an jedem Ende der Zeile durch Änderung der seinem ersten Hauptanschluss zugeführten Spannung durchgeschaltet wird.

29. Verfahren nach Anspruch 28, bei dem die Spannung an den Steueranschlüssen der Schaltelemente (M) konstant gehalten wird, während die dem ersten Hauptanschluss des Schaltelementes an dem oder an jedem Ende der Zeile zugeführte Spannung zu dessen Durchschaltung verändert wird.

30. Verfahren nach Anspruch 28 oder 29, das den Schritt der Änderung des Potentials der ersten Hauptelektrodenbereiche der Fotowandlerelemente der Zeile zur Vorspannung der Steuerbereiche in Relation zu den ersten Hauptelektrodenbereichen in Durchlassrichtung umfasst.

31. Verfahren zur Ansteuerung einer Zeile von Fotowandlerelementen (T) in einer Fotowandlerschaltung nach Anspruch 13 oder zumindest einem der direkt oder indirekt von Anspruch 13 abhängigen Ansprüche 14 bis 27, bei dem die Auffrischung der Fotowandlerelemente durch ein Verfahren nach zumindest einem der Ansprüche 28 bis 30 erfolgt und Signale aus den Fotowandlerelementen (T) ausgelesen werden, indem die Spannung an der Ansteuerleitung (2) in einer Richtung verändert wird, in der die Schaltelemente (M) gesperrt gehalten werden.

32. Verfahren nach Anspruch 31, bei dem die ersten Hauptelektrodenbereiche der Fotowandlerelemente während einer ersten Zeitdauer bei einer Belichtungsperiode, bei der Ladungen in den Steuerbereichen in Abhängigkeit von einfallendem Licht gespeichert werden, auf einer ersten Spannung (-Vvc) gehalten und fotoelektrisch umgesetzte Signale aus den ersten Hauptelektrodenbereichen während einer Leseperiode ausgelesen werden, und
bei dem in einem weiteren Schritt an die ersten Hauptelektrodenbereiche während einer zwischen der Belichtungsperiode und der Leseperiode liegenden zweiten Zeitdauer eine zweite Spannung angelegt wird, die von der ersten Spannung in einer Richtung abweicht, in der die Steuerbereiche in Relation zu den jeweiligen ersten Hauptelektrodenbereichen in Sperrichtung vorgespannt werden.

33. Verfahren nach Anspruch 32, bei dem die Fotowandlerelemente vor der Belichtungsperiode in einem Verfahrensschritt aufgefrischt werden, bei dem die Steuerbereiche in Relation zu den jeweiligen ersten Hauptelektrodenbereichen in Durchlassrichtung vorgespannt werden, während die ersten Hauptelektrodenbereiche auf der zweiten Spannung gehalten werden.

34. Verfahren zur Ansteuerung einer eine Vielzahl von Zeilen der Fotowandlerelemente (T) aufweisenden Fotowandlerschaltung nach zumindest einem der Ansprüche 1 bis 27, bei dem die Fotowandlerelemente durch ein Verfahren nach zumindest einem der Ansprüche 31 bis 33 angesteuert oder die Fotowandlerelemente durch ein Verfahren nach zumindest einem der Ansprüche 28 bis 30 aufgefrischt werden, bei dem die gleichzeitige Auffrischung der Fotowandlerelemente (T) einer Vielzahl von Zeilen erfolgt.

35. Verfahren nach Anspruch 34, bei dem die Fotowandlerschaltung einen Verschluss (200) aufweist und das Verfahren das Öffnen des Verschlusses vor dem Schritt der Auffrischung der Fotowandlerelemente umfasst.

## Revendications

1. Dispositif de photoconversion comportant :
une rangée d'éléments (T) de photoconversion ayant chacun des première et seconde régions d'électrodes principales et une région de commande, des charges étant stockées dans la région de commande en réponse à une lumière incidente ;
un moyen de rafraîchissement comportant (a) une pluralité de moyens de commutation (M) connectés entre certains, respectifs, de la rangée d'éléments (T) de photoconversion, chaque moyen de commutation (M) ayant des première et seconde bornes principales et une borne de commande, les première et seconde bornes principales de chacun desdits moyens de commutation (M) dans la rangée étant couplées respectivement aux régions de commande des éléments (T) de photoconversion de chaque côté de cette rangée, de manière à connecter en série les régions de commande de la rangée d'éléments de photoconversion, et un autre desdits moyens de commutation (M) à au moins une extrémité de la rangée, la seconde borne principale de l'autre moyen de commutation étant couplée à la région de commande de l'élément de photoconversion à l'extrémité de la rangée, et (b) un moyen (18, 19) agencé de façon à mettre en conduction la pluralité de moyens de commutation (M), pour rafraîchir les régions de commande des éléments (T) de photoconversion, en appliquant une variation de tension à la première borne principale de l'autre moyen de commutation (M) à la ou chaque extrémité de la rangée.

2. Dispositif selon la revendication 1, comportant un moyen agencé de façon à bloquer à une valeur constante la tension aux bornes de commande des moyens de commutation (M) pendant l'application de ladite variation de tension à la première borne principale du moyen de commutation à la ou chaque extrémité de la rangée.

3. Dispositif selon la revendication 1 ou la revendication 2, dans lequel le moyen (18, 19) agencé pour mettre en conduction les moyens de commutation comprend un montage émetteur-suiveur (18) dont l'émetteur est connecté à la première borne principale du moyen de commutation (M) à la ou chaque extrémité de la rangée et dont la base est connectée à une borne (19) agencée pour recevoir des variations de la tension devant être appliquée à la première borne principale du moyen de commutation à la ou chaque extrémité de la rangée.

4. Dispositif selon l'une quelconque des revendications 1 à 3, dans lequel la borne de commande de chacun des moyens de commutation (M) dans la rangée est couplée à une électrode de commande pour commander la région de commande de l'un, respectif, des éléments (T) de photoconversion.

5. Dispositif selon la revendication 4, dans lequel l'électrode de commande est en couplage capacitif avec la région de commande de l'élément respectif (T) de photoconversion.

6. Dispositif selon l'une quelconque des revendications précédentes, dans lequel chacun des moyens de commutation (M) comprend un transistor à effet de champ.

7. Dispositif de photoconversion selon l'une quelconque des revendications précédentes, comportant un moyen (4', 13') agencé de façon à modifier les potentiels des premières régions d'électrodes principales des éléments (T) de photoconversion pour polariser dans le sens direct les régions de commande par rapport aux premières régions d'électrodes principales.

8. Dispositif selon la revendication 7, dans lequel ledit moyen (4',13') est agencé de façon à modifier le potentiel des premières régions d'électrodes principales de sensiblement la totalité des éléments de photoconversion en même temps.

9. Dispositif selon la revendication 7 ou la revendication 8, dans lequel le moyen de rafraîchissement comporte en outre un moyen (11, 12 ; ou 20, 21, 50) agencé de façon à modifier le potentiel des régions de commande des éléments (T) de photoconversion pour les polariser dans le sens direct par rapport aux premières régions d'électrodes principales respectives.

10. Dispositif de photoconversion selon l'une quelconque des revendications précédentes, comportant un moyen (11, 12, 5, 6) agencé de façon à lire des signaux de photoconversion à partir des premières régions d'électrodes principales des éléments (T) de photoconversion pendant une période de lecture, et un moyen (4', 13', 4, 13) agencé de façon à bloquer les premières régions d'électrodes principales des éléments de photoconversion à un premier potentiel (-Vvc) à un premier temps pendant la période d'exposition et agencé de façon à porter les premières régions d'électrodes principales à un second potentiel à un second temps entre la période d'exposition et la période de lecture, le second potentiel étant différent du premier potentiel dans un sens tendant à polariser en sens inverse les régions de commande par rapport aux premières régions d'électrodes principales respectives.

11. Dispositif selon l'une quelconque des revendications précédentes, dans lequel chaque élément (T) de photoconversion comporte un transistor bipolaire, et la région de commande est une région de base.

12. Dispositif selon la revendication 11, dans lequel la première région d'électrode principale de chaque élément (T) de photoconversion est une région d'émetteur.

13. Dispositif de photoconversion selon l'une quelconque des revendications précédentes, qui comporte un moyen de lecture comportant une ligne d'attaque (2) couplée aux éléments (T) de photoconversion et aux bornes de commande des moyens de commutation (M), et (d) un moyen (12) agencé de façon à appliquer à la ligne d'attaque (2) une variation de tension, dans un sens qui tend à maintenir hors conduction les moyens de commutation (M), pour lire un signal à partir des éléments (T) de photoconversion.

14. Dispositif de photoconversion selon l'une quelconque des revendications précédentes, dans lequel il y a un autre moyen de commutation à chaque extrémité de la rangée, et le moyen (18, 19) agencé pour mettre en conduction la pluralité de moyens de commutation est agencé de façon à procéder ainsi en appliquant une variation de tension à la première borne principale du moyen de commutation (M) à chaque extrémité de la rangée.

15. Dispositif de photoconversion selon l'une quelconque des revendications précédentes, comportant une pluralité de rangées desdits éléments (T) de photoconversion.

16. Dispositif selon la revendication 15, dans lequel la pluralité de rangées forme un réseau adressable X-Y d'éléments de photoconversion.

17. Dispositif selon la revendication 15 ou la revendication 16, dans lequel le moyen de rafraîchissement comprend un moyen (18, 19 ; ou 4', 13' ; ou 20, 21, 50) agencés de façon à exécuter une opération de rafraîchissement pour les éléments de photoconversion de plus d'une des rangées en même temps.

18. Dispositif selon la revendication 17, dans lequel le moyen de rafraîchissement (18, 19) est agencé de façon à établir la région de commande à un niveau de tension prédéterminé, au moins dans le cas où la tension de la région de commande diffère de la tension prédéterminée dans un premier sens, pour les éléments (T) de photoconversion de plus d'une des rangées en même temps.

19. Dispositif selon la revendication 17, dans lequel le moyen de rafraîchissement (4', 13' ; ou 20, 21, 50) est agencé de façon à polariser dans le sens direct la région de commande, par rapport à la première région d'électrode principale, des éléments (T) de photoconversion de plus d'une des rangées en même temps.

20. Dispositif selon la revendication 19, dans lequel le moyen de rafraîchissement (20, 21, 50) est agencé de façon à polariser dans le sens direct les régions de commande par rapport aux premières régions d'électrodes principales en modifiant le potentiel des régions de commande.

21. Dispositif selon la revendication 19, dans lequel le moyen de rafraîchissement (4', 13') est agencé de façon à polariser dans le sens direct les régions de commande par rapport aux premières régions d'électrodes principales en modifiant le potentiel des premières régions d'électrodes principales.

22. Dispositif selon l'une quelconque des revendications 17 à 21, dans lequel le moyen de rafraîchissement comporte en outre un moyen (4', 13' ; ou 20, 21, 50 ; ou 11, 12) agencé de façon à exécuter une autre opération de rafraîchissement pour les éléments de photoconversion.

23. Dispositif selon la revendication 22, dans lequel l'autre moyen (4', 13' ; ou 20, 21, 50) est agencé de façon à exécuter une autre opération de rafraîchissement en même temps pour les éléments de photoconversion de plus d'une des rangées.

24. Dispositif selon la revendication 22, dans lequel l'autre moyen (11, 12) est agencé de façon à exécuter une autre opération de rafraîchissement à des temps différents pour des éléments de photoconversion de rangées différentes.

25. Dispositif selon l'une quelconque des revendications 22 à 24, dans lequel l'autre moyen (4', 13' ; ou 20, 21, 50 ; ou 11, 12) est agencé de façon à rafraîchir un élément de photoconversion en polarisant dans le sens direct la région de commande par rapport à la première région d'électrode principale.

26. Dispositif selon la revendication 25, dans lequel l'autre moyen (20, 21, 50 ; ou 11, 12) est agencé de façon à polariser dans le sens direct la région de commande par rapport à la première région d'électrode principale en modifiant le potentiel de la région de commande.

27. Dispositif selon la revendication 25, dans lequel l'autre moyen (4', 13') est agencé de façon à polariser dans le sens direct la région de commande par rapport à la première région d'électrode principale en modifiant le potentiel de la première région d'électrode principale.

28. Procédé de rafraîchissement des régions de commande d'une rangée d'éléments de photoconversion d'un dispositif de photoconversion selon l'une quelconque des revendications précédentes, dans lequel ledit moyen de commutation (M) à la ou chaque extrémité de la rangée est mis en conduction en faisant varier la tension appliquée à sa première borne principale.

29. Procédé selon la revendication 28, dans lequel la tension aux bornes de commande des moyens de commutation (M) est maintenue constante tandis qu'on fait varier la tension appliquée à la première borne principale du moyen de commutation à la ou chaque extrémité de la rangée pour le mettre en conduction.

30. Procédé selon la revendication 28 ou la revendication 29, qui comprend l'étape de modification du potentiel des premières régions d'électrodes principales des éléments de photoconversion de la rangée pour polariser dans le sens direct les régions de commande par rapport aux premières régions d'électrodes principales.

31. Procédé pour faire fonctionner une rangée d'éléments (T) de photoconversion dans un dispositif de photoconversion selon la revendication 13 ou l'une quelconque des revendications 14 à 27 en dépendance directe ou indirecte de la revendication 13, comprenant le rafraîchissement des éléments de photoconversion par un procédé selon l'une quelconque des revendications 28 à 30, et la lecture de signaux à partir des éléments (T) de photoconversion en faisant varier la tension de la ligne d'attaque (2) dans un sens qui tend à maintenir hors conduction les moyens de commutation (M).

32. Procédé selon la revendication 31, comprenant le blocage des premières régions d'électrodes principales des éléments de photoconversion à une première tension (-Vvc) à un premier temps pendant une période d'exposition dans laquelle des charges sont stockées dans la région de commande en réponse à une lumière incidente, et une lecture de signaux de photoconversion depuis la première région d'électrode principale pendant une période de lecture,
le procédé comprenant en outre l'étape consistant à porter les premières régions d'électrodes principales à une seconde tension à un second temps entre la période d'exposition et la période de lecture, la seconde tension différant de la première tension dans le sens tendant à inverser la polarisation des régions de commande par rapport aux premières régions d'électrodes principales respectives.

33. Procédé selon la revendication 32, qui comprend le rafraîchissement des éléments de photoconversion avant la période d'exposition par une opération comprenant l'étape de polarisation dans le sens direct des régions de commande par rapport aux premières régions d'électrodes principales respectives tout en bloquant les premières régions d'électrodes principales à la seconde tension.

34. Procédé pour faire fonctionner un dispositif de photoconversion selon l'une quelconque des revendications 1 à 27, le dispositif de photoconversion comportant une pluralité de rangées desdits éléments (T) de photoconversion, le procédé comprenant le fait de faire fonctionner les éléments par un procédé selon l'une quelconque des revendications 31 à 33 ou de rafraîchir les éléments par un procédé selon l'une quelconque des revendications 28 à 30, dans lequel des éléments (T) de photoconversion de plusieurs rangées sont rafraîchis en même temps.

35. Procédé selon la revendication 34, dans lequel le dispositif de photoconversion comporte un obturateur (200), et le procédé comprend l'ouverture de l'obturateur avant ladite étape de rafraîchissement des éléments de photoconversion.
